# EUROPEAN PATENT APPLICATION

(11) **EP 2 765 173 A1**
(43) Date of publication of application: **13.08.2014**
(21) Application number: 12838614.1
(22) Date of filing: 05.10.2012
(51) Int. Cl.: C09J 201/00, C09J 9/02, C09J 11/04, H01B 1/22, H01L 33/60, H01R 11/01

(54) **ANISOTROPIC CONDUCTIVE ADHESIVE AND METHOD FOR PRODUCING SAME, AND LIGHT-EMITTING DEVICE AND METHOD FOR PRODUCING SAME**

(30) Priority: 07.10.2011 JP 2011222498
(71) Applicant: Dexerials Corporation, Tokyo 141-0032 (JP)
(72) Inventor: ISHIGAMI Akira, Kanuma-shi Tochigi 322-8503 (JP); KANISAWA Shiyuki, Kanuma-shi Tochigi 322-8503 (JP); NAMIKI Hidetsugu, Kanuma-shi Tochigi 322-8503 (JP); UMAKOSHI Hideaki, Kanuma-shi Tochigi 322-8503 (JP); AOKI Masaharu, Kanuma-shi Tochigi 322-8503 (JP)
(74) Representative: Körber, Martin Hans
(86) International application number: PCT/JP2012/076011
(87) International publication number: WO 2013/051708

(57) **Abstract**

The present invention is made to provide an anisotropic conductive adhesive which uses conductive particles where a silver-based metal is used as a conductive layer, having high light reflectance and excellent migration resistance. The anisotropic conductive adhesive (1)includes light reflective conductive particles (3) in an insulating adhesive resin (2). The light reflective conductive particle (3) includes a light reflective metal layer (31) made of a metal having at least 60% of reflectance at a peak wavelength of 460 nm formed on the surface of a resin particle (30) as a core, and a coating layer made of a silver alloy formed on the surface of the light reflective metal layer (31). The light reflective metal layer is preferably formed by a plating method.

## Description

### Technical Field

The present invention generally relates to an anisotropic conductive adhesive, and more particularly relates to a technology on an anisotropic conductive adhesive used for flip-chip mounting of semiconductor elements (such as, an LED (light-emitting diode)) on a wiring substrate.

### Background Art

In recent years, attention has been focused on an optical functional element using an LED.

In such an optical functional element, for example, in order to reduce its size, flip-chip mounting is performed in which an LED chip is directly mounted on a wiring substrate.

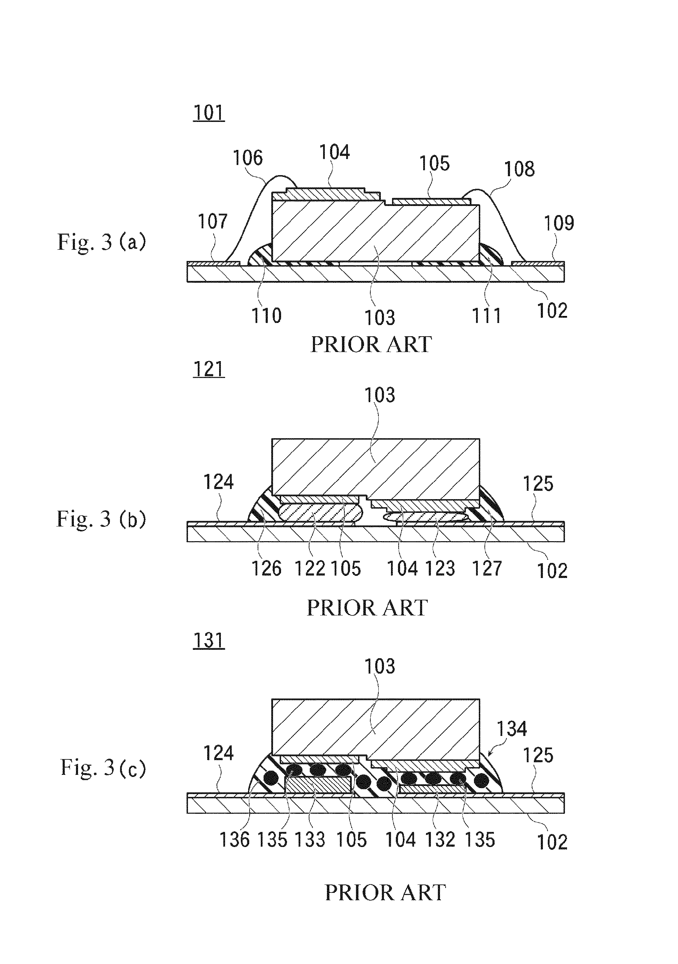

As the method of performing the flip-chip mounting of an LED chip on a wiring substrate, as shown in Figs. 3 (a) to 3(c), various methods are conventionally known.

Fig. 3(a) shows a mounting method using wire bonding.

In a light-emitting device 101 shown in Fig. 3(a), the LED chip 103 is fixed onto the wiring substrate 102 with a die bonding adhesive 110 and 111 in such a manner that a first and a second electrodes 104 and 105 of an LED chip 103 face the upper side (the opposite side to a wiring substrate 102).

Then, using bonding wires 106 and 108, first and second pattern electrodes 107 and 109 on the wiring substrate 102 are electrically connected to the first and second electrodes 104 and 105 of the LED chip 103, respectively.

Fig. 3(b) shows a mounting method using a conductive paste.

In a light-emitting device 121 shown in Fig. 3(b), the first and second electrodes 104 and 105 are electrically connected to a first and a second pattern electrodes 124 and 125 of the writing substrate 102 by a conductive paste 122 and 123 (such as, a copper paste) for example, in a manner such that the first and second electrodes 104 and 105 of the LED chip 103 face the side of the wiring substrate 102, and the LED chip 103 is adhered onto the wiring substrate 102 with a sealing resin 126 and 127.

Fig. 3(c) shows a mounting method using an anisotropic conductive adhesive.

In a light-emitting device 131 shown in Fig. 3(c), the first and second electrodes 104 and 105 are electrically connected to bumps 132 and 133 provided on the first and second pattern electrodes 124 and 125 of the wiring substrate 102 by conductive particles 135 in the anisotropic conductive adhesive 134 in such a manner that with the first and second electrodes 104 and 105 of the LED chip 103 face the side of the wiring substrate 102, and the LED chip 103 is adhered onto the wiring substrate 102 by an insulating adhesive resin 136 in the anisotropic conductive adhesive 134.

However, there are various problems in the conventional technologies as discussed above.

First, in the mounting method using the wire bonding, because the bonding wires 106 and 108 formed of gold absorb light having, for example, a wavelength of 400 to 500 nm, the light emission efficiency is reduced.

In this method, because the die bonding adhesive 110 and 111 are cured using an oven, the curing time is long, and it is difficult to enhance the production efficiency.

On the other hand, in the mounting method using the conductive paste 122 and 123, because the adhesive force of the conductive paste 122 and 123 alone is low, it is necessary to reinforce with the sealing resin 126 and 127, and the sealing resin 126 and 127 causes light to diffuse into the conductive paste 122 and 123, and light to be absorbed inside the conductive paste 122 and 123, and in the result, the light emission efficiency is reduced.

Furthermore, in this method, because the sealing resin 126 and 127 is cured using an oven, the curing time is long, so that it is difficult to enhance the production efficiency.

On the other hand, in the mounting method using the anisotropic conductive adhesive 134, because the color of the conductive particles 135 inside the anisotropic conductive adhesive 134 is brown, the color of the insulating adhesive resin 136 becomes brown, and light is absorbed inside the anisotropic conductive adhesive 134, so that the light emission efficiency is reduced.

In order to solve the above-discussed problems, providing an anisotropic conductive adhesive without reducing luminance efficiency is proposed by forming a conductive film using silver (Ag) having high reflection ratio of light and low electric resistance so as to suppress light absorption.

However, because silver is a chemically unstable material, it disadvantageously easily undergoes oxidation and sulfurization, and after thermal compression, migration occurs by energization, and thus, the adhesion strength is disadvantageously degraded by a break in a wiring part and the degradation of an adhesive.

In order to solve the foregoing problems, for example, as discussed in patent document 4, an Ag-based thin film alloy which is excellent in reflectance, corrosion resistance and migration resistance is proposed.

Although coating of the surface of the conductive particles with this Ag-based thin film alloy enhances the corrosion resistance and the migration resistance, when the Ag-based thin film alloy is used as the outermost layer, and nickel, for example, is used as a foundation layer, the reflectance of nickel is lower than that of Ag, and thus, there is a problem that the reflectance of the whole of the conductive particles is reduced.

### Related Art Document

### Patent Document

Patent document 1: JPA No. 2005-120375
Patent document 2: JPA No. H05-152464
Patent document 3: JPA No. 2003-26763
Patent document 4: JPA No. 2008-266671

### Disclosure of the Invention

### Problems to be Solved by the Invention

The present invention is made by consideration to solve the problems of the conventional technologies as discussed above, an object of the present invention is to provide the technology of an anisotropic conductive adhesive which uses conductive particles where a silver-based metal is used as a conductive layer having high light reflectance and excellent migration resistance.

### Means for Solving the Problem

To achieve the above object, according to the present invention, there is provided an anisotropic conductive adhesive comprising light reflective conductive particles in an insulating adhesive resin, wherein the light reflective conductive particle includes a light reflective metal layer made of a metal having at least 60% of a reflectance at a peak wavelength of 460 nm formed on a surface of a resin particle as a core, and a coating layer made of a silver alloy formed on a surface of the light reflective metal layer.

The present invention is the anisotropic conductive adhesive, wherein the light reflective metal layer is made of at least one metal selected from a group consisting of nickel, gold and silver.

The present invention is a method of manufacturing an anisotropic conductive adhesive including light reflective conductive particles in an insulating adhesive resin, wherein the light reflective conductive particle includes a light reflective metal layer made of a metal having at least 60% of a reflectance at a peak wavelength of 460 nm formed on a surface of a resin particle as a core, and a coating layer made of a silver alloy formed on a surface of the light reflective metal layer, the method includes the step of forming the light reflective metal layer by a plating method.

The present invention is a A light-emitting device includes a wiring substrate having a connection electrode as a pair and a light-emitting element having a connection electrode corresponding to the connection electrode of the wiring substrate as a pair, wherein an anisotropic conductive adhesive includes light reflective conductive particles in an insulating adhesive resin, wherein the light reflective conductive particle is formed of the light reflective metal layer made of a metal having at least 60% of a reflectance at a peak wavelength of 460 nm formed on a surface of a resin particle as a core, and a coating layer made of a silver alloy formed on a surface of the light reflective metal layer, and wherein the light-emitting element is adhered by the anisotropic conductive adhesive onto the wiring substrate, and the connection electrode of the light-emitting element is electrically connected to the corresponding connection electrode of the wiring substrate through the conductive particles of the anisotropic conductive adhesive.

The present invention is a method of manufacturing a light-emitting element includes the steps of preparing a wiring substrate having a connection electrode as a pair and a light-emitting element having a connection electrode corresponding to the connection electrode of the wiring substrate as a pair, arranging an anisotropic conductive adhesive between the light-emitting element and the light-emitting element in a manner such that the connection electrode of the wiring substrate is arranged facing direction to the connection electrode of the light-emitting element, and thermally compressing the light emitting element to the wiring substrate, wherein an anisotropic conductive adhesive includes light reflective conductive particles in an insulating adhesive resin, and wherein the light reflective conductive particle is formed of the light reflective metal layer made of a metal having at least 60% of a reflectance at a peak wavelength of 460 nm formed on a surface of a resin particle as a core, and a coating layer made of a silver alloy formed on a surface of the light reflective metal layer.

In the present invention, because the conductive partible of the anisotropic conductive adhesive has a light reflective metal layer made of metal having at least 60% of reflection ratio at peak wavelength of 460 nm formed on a surface of the resin particle as a core and a coating layer made of silver alloy having high reflection ratio similar to the reflection ratio of the light reflective metal layer formed on a surface of the light reflective metal layer, it is possible to suppress adsorption of light by the anisotropic conductive adhesive as a minimum.

Consequently, when the anisotropic conductive adhesive of the present invention is used to mount the light-emitting element on the wiring substrate, it is possible to provide the light-emitting device that can efficiently take out light without reducing the light emission efficiency of the light-emitting element.

In the anisotropic conductive adhesive of the present invention, because the coating layer made of the silver alloy of which migration does not easily occur is formed on the surface of the light reflective metal layer, it is possible to enhance migration resistance.

On the other hand, according to the method of the present invention, because the light-emitting device which provides the significant effects discussed above can be manufactured by the arrangement of the anisotropic conductive adhesive and the simple and rapid thermal compression process, it is possible to significantly enhance the production efficiency.

### Advantages of the Invention

According to the present invention, it is possible to provide the technology of an anisotropic conductive adhesive using conductive particles where a silver-based metal is used as a conductive layer and having high light reflectance and excellent migration resistance.

### Brief Description of Drawings

Fig. 1 (a) is a cross-sectional view schematically showing the configuration of an anisotropic conductive adhesive according to the present invention.
Fig. 1(b) shows an enlarged cross-sectional view showing the configuration of a conductive particle used in the present invention.
Fig. 1(c) is a cross-sectional view showing the configuration of an example of a light-emitting device according to the present invention.
Figs. 2 (a) to 2(c) are Diagrams showing an embodiment of a process of manufacturing the light-emitting device according to the present invention.
Fig. 3 (a) are a diagram showing a mounting method using wire bonding.
Fig. 3(b) is a diagram showing a mounting method using a conductive paste.
Fig. 3(c) is a diagram showing a mounting method using the anisotropic conductive adhesive.

### Best Mode for Carrying Out the Invention

A preferred embodiment of the present invention will be discussed in detail below with reference to accompanying drawings.

In particular, an anisotropic conductive adhesive in paste form can be suitably applied to the present invention.

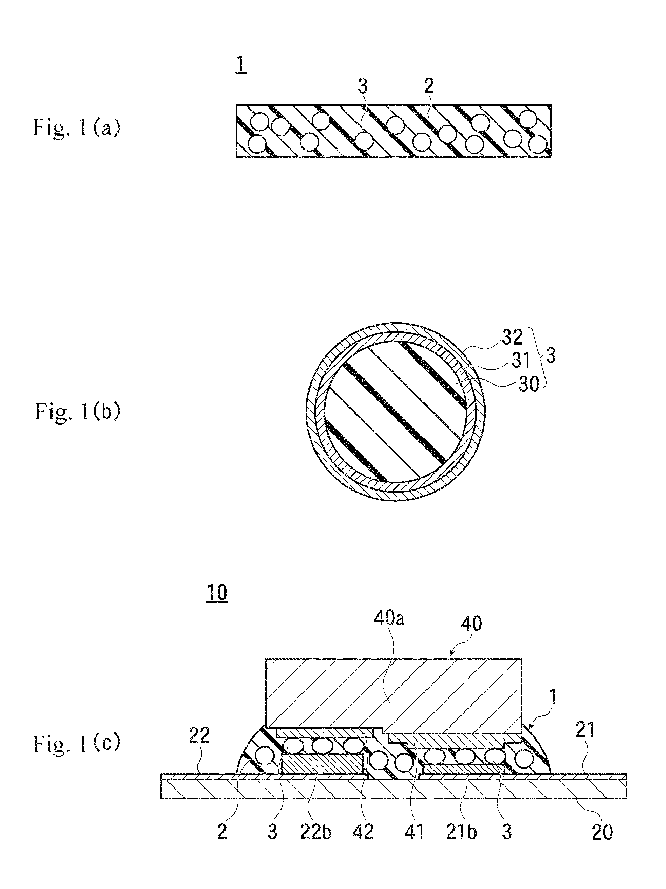

Fig. 1 (a) is a cross-sectional view schematically showing the structure of an anisotropic conductive adhesive according to the present invention, Fig. 1(b) is an enlarged cross-sectional view showing the structure of conductive particles used in the present invention, and Fig. 1(c) is a cross-sectional view showing the structure of an embodiment of a light-emitting device according to the present invention.

As shown in Fig. 1(a), in the anisotropic conductive adhesive 1 of the present invention, a plurality of conductive particles 3 which are dispersed in an insulating adhesive resin 2.

In the present invention, the insulating adhesive resin 2 is not particularly limited, however, in terms of superiority of transparency, adhesion, heat resistance, mechanical strength and electrical insulation, a composition containing an epoxy resin and a curing agent thereof can be preferably used.

Specifically, examples of the epoxy resin include an alicyclic epoxy compound, a heterocyclic epoxy compound and a hydrogenated epoxy compound. As the alicyclic epoxy compound, an alicyclic epoxy compound having at least two epoxy groups within a molecule is preferably used. It may be liquid form or solid form. Specific examples include glycidyl hexahydrobisphenol A, 3,4-epoxycyclohexenylmethyl-3' and 4'-epoxycyclohexenecarboxylate. Among them, because optical transparency suitable for, for example, the mounting of an LED element can be acquired in the cured material, and rapid curing is excellently achieved, glycidyl hexahydrobisphenol A, 3,4-epoxycyclohexenylmethyl-3' or 4'-epoxycyclohexenecarboxylate can be preferably used.

As the heterocyclic epoxy compound, an epoxy compound having a triazine ring can be used, and 1,3,5-tris(2,3-epoxypropyl)-1,3,5-triazine-2,4,6-(1H,3H,5H) -trione can be particularly preferably used.

As the hydrogenated epoxy compound, a hydrogen additive of the alicyclic epoxy compound or the heterocyclic epoxy compound discussed above or another known hydrogenated epoxy resin can be used.

As long as the effects of the present invention are not degraded, in addition to these epoxy compounds, another epoxy resin may be used together. Examples thereof include the following known epoxy resins: glycidyl ether 1 glycerin which is obtained by making epichlorohydrin react with a polyhydric phenol such as bisphenol A, bisphenol F, bisphenol S, tetramethyl bisphenol A, diaryl bisphenol A, hydroquinone, catechol, resorcin, cresol, tetrabromobisphenol A, trihydroxy biphenyl, benzophenone, bis-resorcinol, bisphenol hexafluoroacetone, tetramethyl bisphenol A, tetramethyl bisphenol F, tris(hydroxyphenyl)methane, bixylenol, phenol novolac or cresol novolac; polyglycidyl ether lp-oxybenzoic acid which is obtained by making epichlorohydrin react with an aliphatic polyhydric alcohol such as neopentyl glycol, ethylene glycol, propylene glycol, thylene glycol, hexylene glycol, polyethylene glycol or polypropylene glycol; glycidyl ether ester 1 phthalic acid which is obtained by making epichlorohydrin react with a hydroxycarboxylic acid such as, β-oxy naphthoic acid; polyglycidyl ester 1 aminophenol which is obtained from a polycarboxylic acid such as methylphthalic acid, isophthalic acid, terephthalic acid, tetra hydro phthalic acid, endomethylene tetrahydrophthalic acid, endomethylene hexahydrophthalic acid, trimellitic acid or polymerized fatty acid; glycidylamino glycidyl ester 1 aniline which is obtained from glycidylamino glycidyl ether 1 amino benzoic acid obtained from aminoalkylphenol; and glycidyl amine 1 epoxy polyolefin that is obtained from toluidine, tribromoaniline, xylylenediamine, diaminocyclohexane, bis aminomethyl cyclohexane, 4,4'-diaminodiphenyl methane or 4,4' -diaminodiphenyl sulfone. As the curing agent, an acid anhydride, an imidazole compound, dicyan or the like can be used. Among them, an acid anhydride which is unlikely to discolor a curing agent, in particular, an alicyclic acid anhydride curing agent, can be preferably used. Specifically, methylhexahydrophthalic anhydride or the like can be preferably used.

When an alicyclic epoxy compound and an alicyclic acid anhydride curing agent are used together, because there is a tendency that when the amount of alicyclic acid anhydride curing agent used is excessively low, the amount of uncured epoxy is increased whereas when the amount of alicyclic acid anhydride curing agent used is excessively high, the effect of the excessive amount of curing agent facilitates the corrosion of an adherend material, with respect to 100 weight parts of the alicyclic epoxy compound, 80 to 120 weight parts can be preferably used, and 95 to 105 weight parts can be more preferably used.

The conductive particle 3 of the present invention includes a resin particle 30 as a core, a light reflective metal layer 31 is formed on the surface of the resin particle 30 and a coating layer 32 made of silver alloy is formed on the surface of the light reflective metal layer 31.

In the present invention, although the resin particle 30 is not particularly limited, in order to obtain a high reliability of conductivity, it is possible to preferably use, for example, a resin particle formed of cross-linked polystyrene, benzoguanamine, nylon or PMMA (polymethacrylate) or the like.

Although the size of the resin particle 30 is not particularly limited in the present invention, in order to obtain a high reliability of conductivity, it is possible to preferably use the resin particle having an average particle diameter of 3 µm to 5 µm.

The light reflective metal layer 31 formed on the surface of the resin particle 30 is formed of a metal material having at least 60% of reflectance at a peak wavelength of 460 nm which is a peak wavelength of blue light, and is more preferably 95% of reflectance or more.

As the material of the light reflective metal layer 31, a gold (Au) layer formed on the surface of nickel (Ni) layer, and a silver consisting of a single layer can be used.

Among them, in order to more enhance its reflectance, it is preferable to use silver.

In this case, it is preferable to use silver having a purity (proportion in a metal component) of at least 98 weight %.

In the present invention, although the method of forming the light reflective metal layer 31 is not particularly limited, in order to more enhance the reflectance by smoothing the surface, it is preferable to adopt a plating method.

In the present invention, although the thickness of the light reflective metal layer 31 is not particularly limited, in order to acquire a desired reflectance, it is preferable to set the thickness at least 0.05 µm.

The coating layer 32 formed on the surface of the light reflective metal layer 31 is formed with an alloy made mainly of silver (in the present specification, referred to as a "silver alloy").

In the present invention, the silver alloy of the coating layer 32 having at least 95 weight % of a silver content in the meal is preferably used.

In this case, in order to more enhance the reflectance, it is preferable to configure the light reflective metal layer 31 in a manner such that proportion of the silver included in the metal of the light reflective metal layer 31 is higher than the proportion of silver inlcuded in the metal of the coating layer 32.

Examples of metals other than silver contained in the silver alloy include: Bi, Ti, Zr, Hf, V, Nb, Ta, Cr, Mo, W, Fe, Ru, Co, Rh, Ir, Ni, Pd, Pt, Cu, Au, Zn, Al, Ga, In, Si, Ge and Sn.

In the present invention, as the material of the coating layer 32, a material having at least 60 % of reflectance at a peak wavelength of 460 nm which is a peak wavelength of blue light, more preferably 90% of reflectance or more.

In the present invention, although the method of forming the coating layer 32 is not particularly limited, in view of uniform coating of the silver alloy, it is preferable to adopt a sputtering method.

The sputtering method is one of the methods of forming a thin film on an object, and is performed in vacuum containing a sputter gas (such as, argon). In the sputtering method, with the interior of a container being made vacuum ambience, a voltage is applied between an object to be processed and a sputtering target so as to generate grow discharge. Electrons and ions generated in this way are made to collide with the target at high speed, and thus, the particles of the target material are forced out, and the particles (sputter particles) are adhered to the surface of the object to be film-formed, and then, a thin film is formed.

Here, as a method for forming a thin film on fine particles by the sputtering as in the present invention, it is preferable to set the fine particles dispersed as primary particles in a container inside a device and to rotate the container to make the fine particles flow. In other words, by performing the sputtering on the fine particles in its fluidized state, it is possible to make the sputter particles of the target material collide with the entire surface of the individual fine particles so as to form a thin film over the entire surface of the individual fine particles.

As the sputtering method applied to the present invention, it is possible to adopt a known sputtering method (such as, a bipolar sputtering method, a magnetron sputtering method, a high-frequency sputtering method or a reactive sputtering method).

In the present invention, although the thickness of the coating layer 32 is not particularly limited, in view of acquire desired migration resistance, it is preferable to set the thickness at least 0.07 µm.

In the present invention, although a content amount of the conductive particles 3 in the insulating adhesive resin 2 is not particularly limited, with consideration given to the acquisition of light reflectance, migration resistance and insulation, it is preferable to contain 1 weight part or more but 100 weight parts or less of the conductive particles 3 in 100 weight parts of the insulating adhesive resin 2.

In order to manufacture the anisotropic conductive adhesive 1 of the present invention, for example, the conductive particles 3 dispersed in a predetermined solvent are added to a solution in which a predetermined epoxy resin or the like is solved, and they are mixed so as to prepare a binder paste.

Here, when an anisotropic conductive adhesive film is manufactured, for example, a separation film (such as, a polyester film) is coated with this binder paste, and after drying, a cover film is laminated, and thus, the anisotropic conductive adhesive film having a desired thickness is obtained.

On the other hand, as shown in Fig. 1(c), the light-emitting device 10 of the present embodiment includes, for example, a wiring substrate 20 made of ceramic and a light-emitting element 40 which is mounted on the wiring substrate 20.

In the present embodiment, the first and second connection electrodes 21 and 22 are formed by, for example, silver plating into a predetermined pattern on the wiring substrate 20, as a pair of connection electrodes.

For example, terminal portions 21b and 22b which are formed of stud bumps and having convex shape are respectively provided on the adjacent end portions of the first and second connection electrodes 21 and 22.

On the other hand, as the light-emitting element 40, for example, an LED (light-emitting diode) which emits visible light having a peak wavelength of at least 400 nm and at most 500 nm is used.

In the present invention, in particular, an LED for blue color having a peak wavelength of around 460 nm can be suitably used.

In the light-emitting element 40, its main body portion 40a is formed in the shape of, for example, a rectangular parallelepiped, and on one surface, first and second connection electrodes 41 and 42 which are an anode electrode and a cathode electrode are provided.

Sizes and shapes are set in a manner such that when the terminal portions 21b and 22b of the first and second connection electrodes 21 and 22 of the wiring substrate 20 and the first and second connection electrodes 41 and 42 of the light-emitting element 40 are arranged opposite each other, the connection portions thereof face each other.

The light-emitting element 40 is adhered onto the wiring substrate 20 by the cured anisotropic conductive adhesive 1 discussed above.

Furthermore, the first and second connection electrodes 41 and 42 of the light-emitting element 40 are electrically connected to the corresponding first and second connection electrodes 21 and 22 (the terminal portions 21b and 22b) of the wiring substrate 20, respectively, through the conductive particles 3 of the anisotropic conductive adhesive 1.

Specifically, the first connection electrode 41 of the light-emitting element 40 is electrically connected to the terminal portion 21b of the first connection electrode 21 of the wiring substrate 20 by contact with the conductive particles 3, and the second connection electrode 42 of the light-emitting element 40 is electrically connected to the terminal portion 22b of the second connection electrode 22 of the wiring substrate 20 by contact with the conductive particles 3.

On the other hand, the first connection electrode 21 of the wiring substrate 20 and the first connection electrode 41 of the light-emitting element 40, and the second connection electrode 22 of the wiring substrate 20 and the second connection electrode 42 of the light-emitting element 40 are insulated from each other by the insulating adhesive resin 2 in the anisotropic conductive adhesive 1.

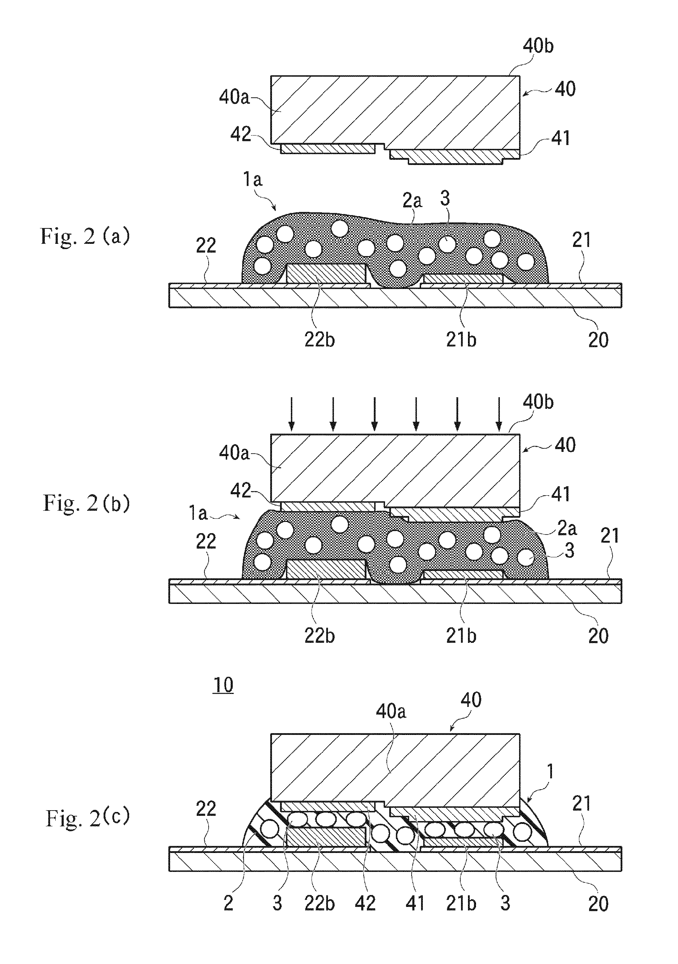

Figs. 2 (a) to 2(c) are diagrams showing an embodiment of a process for manufacturing the light-emitting device of the present invention.

First, as shown in Fig. 2(a), the wiring substrate 20 having a pair of first and second connection electrodes 21 and 22 and the light-emitting element 40 having the first and second connection electrodes 41 and 42 which are corresponding to the first and second connection electrodes 21 and 22 of the wiring substrate 20 are prepared.

Then, in a state where the terminal portions 21b and 22b of the first and second connection electrodes 21 and 22 of the wiring substrate 20 and the first and second connection electrodes 41 and 42 of the light-emitting element 40 are arranged opposite each other, an uncured anisotropic conductive adhesive 1a in paste form is arranged so as to cover the terminal portions 21b and 22b of the first and second connection electrodes 21 and 22 of the wiring substrate 20.

For example, when the uncured anisotropic conductive adhesive 1a is formed in the shape of a film, the uncured anisotropic conductive adhesive 1a is adhered, for example, with an adhering device (not shown), to a predetermined position of the surface on the side where the first and second connection electrodes 21 and 22 of the wiring substrate 20 are provided.

As shown in Fig. 2(b), the light-emitting element 40 is placed on the uncured anisotropic conductive adhesive 1a, and the surface of the light emission side of the light-emitting element 40, that is, the surface 40b which is the opposite side to the side where the first and second connection electrodes 41 and 42 are provided is pressurized and heated with a thermal compression head (not shown) at predetermined pressure and temperature.

Thereby, the insulating adhesive resin 2a of the uncured anisotropic conductive adhesive 1a is cured, and as shown in Fig. 2(c), the light-emitting element 40 is adhered and fixed onto the wiring substrate 20 by the adhesion of the cured anisotropic conductive adhesive 1.

In this thermal compression process, a plurality of conductive particles 3 make contact with the terminal portions 21b and 22b of the first and second connection electrodes 21 and 22 of the wiring substrate 20 and the first and second connection electrodes 41 and 42 of the light-emitting element 40, and they are pressurized, and in the result, the first connection electrode 41 of the light-emitting element 40 and the first connection electrode 21 of the wiring substrate 20, and the second connection electrode 42 of the light-emitting element 40 and the second connection electrode 22 of the wring substrate 20 are and electrically connected, respectively.

On the other hand, the first connection electrode 21 of the wiring substrate 20 and the first connection electrode 41 of the light-emitting element 40, and the second connection electrode 22 of the wiring substrate 20 and the second connection electrode 42 of the light-emitting element 40 are insulated from each other by the insulating adhesive resin 2 in the anisotropic conductive adhesive 1.

Then, by the following process, the intended light-emitting device 10 is obtained.

In the present embodiment as discussed above, because the conductive particle 3 of the anisotropic conductive adhesive 1 is made by forming the light reflective metal layer 31 made of the metal having 60% of reflectance at a peak wavelength of 460 nm on the surface of the resin particle 30 as a core, and furthermore, the covering layer 32 made of the silver alloy having high reflectance similar to the light reflective metal layer 31 is formed on the surface of the light reflective metal layer 31, so that it is possible to minimize the absorption of light by the anisotropic conductive adhesive 1.

Consequently, when the anisotropic conductive adhesive 1 of the present embodiment is used to mount the light-emitting element 40 on the wiring substrate 20, it is possible to provide the light-emitting device 10 that can efficiently extract light without reducing the light emission efficiency of the light-emitting element 40.

In the anisotropic conductive adhesive 1 of the present embodiment, the coating layer 32 made of the silver alloy where migration is unlikely to occur is formed on the surface of the light reflective metal layer 31, and thus, it is possible to enhance migration resistance.

On the other hand, in the method according to the present embodiment, the light-emitting device 10 can be manufactured by the simple and rapid processes, and by the process of arranging the anisotropic conductive adhesive 1 and the thermal compression process, it is possible to significantly enhance the production efficiency.

The present invention is not limited to the embodiment discussed above, and various modifications can be performed.

For example, the light-emitting device 10 shown in Fig. 1(c) and Fig. 2(c) is schematically shown by simplifying its shape and size, so that the shapes, the sizes, the numbers and the like of the wiring substrate and the connection electrodes of the light-emitting element can be changed as necessary.

The present invention can be applied not only to, for example, the light-emitting element for blue color having a peak wavelength of around 460 nm but also to light-emitting elements having various peak wavelengths.

However, the present invention is most effective when the present invention is applied to the light-emitting element having a peak wavelength of around 460 nm.

### <Examples>

Although the present invention will be specifically discussed below using examples and comparative examples, the present invention is not limited to the following examples.

### <Preparation of adhesive composition>

An adhesive composition is prepared using 50 weight parts of an epoxy resin (sold under the name "TEPIC" made by Nissan Chemical Industries, Ltd.), 50 weight parts of methylhexahydrophthalic anhydride (sold under the name "MH-700" made by New Japan Chemical Co. , Ltd.) as a curing agent, 2 weight parts of a curing accelerator (sold under the name "2E4MZ" made by Shikoku Chemicals Corporation) and toluene as a solvent.

### <Preparation of conductive particles>

### [Example particle 1]

A light reflective metal layer made of silver (Ag) having a thickness of 0.3 µm is formed by an electroless plating method on the surface of resin particles (sold under the name "Art Pearl J-6P" made by Negami Chemical Industrial Co., Ltd.) made of a cross-linked acrylic resin having an average particle diameter of 5 µm.

In this case, as a plating solution (sold under the name "Presser RGA-14" made by Uyemura & Co., Ltd.) is used.

A coating layer made of a silver alloy having a thickness of 0.13 µm is formed by a sputtering method on the surface of the light reflective metal layer.

In this case, as a sputtering device, a powder sputtering device made by Kyoritsu Co., Ltd. is used, and as a sputtering target, an Ag-Nd-Cu alloy target made by a dissolution and casting method is used.

The Ag-Nd-Cu alloy target contains Ag, Nd and Cu at the following ratio: Ag : Nd : Cu in the range of 98.84 to 99.07 : 0.36 to 0.44 : 0.57 to 0.72 weight %.

### [Example particle 2]

A light reflective metal layer made of nickel/gold having a thickness of 0.13 µm is formed by an electroless plating method on the surface of a resin particle. The thickness of a coating layer made of a silver alloy is set at 0.4 µm. Example particle 2 is produced under the same conditions as in example particle 1 except as discussed above.

### [Example particle 3]

Example particle 3 is produced under the same conditions as in example particle 2 except that the thickness of a coating layer made of nickel/gold is set at 0.13 µm.

### [Example particle 4]

Example particle 4 is produced under the same conditions as in example particle 1 except that the thickness of a coating layer made of a silver alloy is set at 0.05 µm.

### [Example particle 5]

Example particle 5 is produced under the same conditions as in example particle 3 except that a light reflective metal layer made of only nickel is formed by an electroless plating method on the surface of resin particles.

### [Comparative example particle 1]

Comparative example particle 1 is produced under the same conditions as in example particle 1 except that while a light reflective metal layer made of silver is formed by an electroless plating method on the surface of resin particles, a coating layer is not formed.

### [Comparative example particle 2]

Comparative example particle 2 is produced under the same conditions as in example particle 5 except that a coating layer made of gold (Au) having a thickness of 0.3 µm is formed.

### [Comparative example particle 3]

Comparative example particle 3 is produced under the same conditions as in example particle 1 except that while nickel plating is applied to the surface of resin particles, a coating layer is not formed.

### <Production of anisotropic conductive adhesive>

15 weight parts of each of example particles 1 to 5 and comparative example particles 1 to 3 are mixed with 100 weight parts of the adhesive composition discussed above (except the solvent), and thus anisotropic conductive adhesives of examples 1 to 5 and comparative examples 1 to 3 are obtained. (Evaluation)

### (1) Reflectance

The anisotropic conductive adhesives of examples 1 to 5 and comparative examples 1 to 3 are applied onto smooth plates in a manner such that each thickness after being dried is 70 µm, and are cured, and thus, samples for reflectance measurement are produced.

For each of the samples, a reflectance is measured at a wavelength of 460 nm, which is a blue wavelength by a spectroscopic colorimeter (CM-3600 made by Konica Minolta, Inc.). The results thereof are shown in table 1.

### (2) Migration resistance

The anisotropic conductive adhesives of examples 1 to 5 and comparative examples 1 to 3 are used to adhere and fix (flip-chip mount) an LED element (0.35 x 0.35 mm square) on a substrate made of ceramic, and thus LED element mounting modules are produced.

On each of the produced LED element mounting modules, a high-temperature and high-humidity test of applying energization in an environment of a temperature of 85°C and a relative humidity of 85% RH is performed for 100 hours and 500 hours, and individual appearances are visually observed with a microscope. The results thereof are shown in table 1.

Here, a case where no dendrite (dendritically extending precipitation) is produced in the anisotropic conductive adhesive is represented by "○", and a case where dendrite is produced in the anisotropic conductive adhesive is represented by "Δ".

### (3) Conduction reliability

In the migration resistance test discussed above, an electrical measurement is performed and a Vf value is measured with a curve tracer (TCT-2004 made by Kokuyo Electric Co., Ltd.) for each of 100 hours, 500 hours and 1000 hours, and existence or non-existence of break of conduction (open), and existence or non-existence of occurrence of short circuit are also observed. In other words, a case where the continuity is determined to be broken is represented by "○" in evaluation, and a case where a short-circuit occurs in a part of a measurement pattern is represented by "Δ" in evaluation. The results thereof are shown in table 1.

**Table 1 Configuration and evalucation results of examples and comparative examples**

| | | | Example 1 | Example 2 | Example 3 | Example 4 | Example 5 | Comparative example 1 | Comparative example 2 | Comparative example 3 |
|---|---|---|---|---|---|---|---|---|---|---|
| Plating material | Material of light reflective metal layer | | Ag | Ni/Au | Ni/Au | Ag | Ni | Ag | Ni | Ni |
| Spputter material | Coating layer | Material | Ag·Nd·Cu | Ag·Nd·Cu | Ag·Nd·Cu | Ag·Nd·Cu | Ag·Nd·Cu | - | Au | - |
| | | Thickness (*µ*m) | 0.13 | 0.4 | 0.13 | 0.05 | 0.13 | - | 0.3 | - |
| | | Reflectance [%] | 90 | 90 | 90 | 90 | 90 | 95 | 43 | 52 |
| Reflectance (460nm) | Adhesive cured material [%] | | 38 | 30 | 24 | 26 | 39 | 40 | 18 | 15 |
| Migration resistance | 100 hour | | ○ | ○ | ○ | ○ | ○ | ○ | ○ | ○ |
| | 500 hour | | ○ | ○ | ○ | ○ | Δ | Δ | ○ | ○ |
| Conduction reliability | 100 hour | | ○ | ○ | ○ | ○ | ○ | ○ | ○ | ○ |
| | 500 hour | | ○ | ○ | ○ | ○ | ○ | ○ | ○ | ○ |
| | 1000 hour | | ○ | ○ | ○ | ○ | ○ | × | ○ | ○ |

| | | | | | | | | | | |
|---|---|---|---|---|---|---|---|---|---|---|
| Note: Ag-Nd-Cu alloy target contains Ag, Nd and Cu at the following ratio: Ag : Nd : Cu in the range of 98.84 to 99.07 : 0.36 to 0.44 :0.57 to 0.72 weight %. | | | | | | | | | | |

### <Example 1>

As shown in table 1, it is clear that the resin cured material using the anisotropic conductive adhesive of example 1 shows a reflectance of 38%, and shows an equivalent value of the resin cured material using the conductive particles without provision of a coating layer on a light reflective metal layer of pure silver shown in comparative the example 1.

In the observation of the appearance of the LED element mounting module produced using the anisotropic conductive adhesive of the example 1, no dendrite is observed after the high-temperature and high-humidity test of 500 hours, and the migration resistance is also satisfactory.

Furthermore, the electrical characteristics remained the same from the initial state, and the conduction reliability is also satisfactory.

### <Example 2>

The resin cured material using the anisotropic conductive adhesive of the example 2 where the light reflective metal layer of the conductive particles is made of nickel/gold plating shows a reflectance of 30%, and did not reach the resin cured material of the example 1 but is sufficiently on a practical level.

In the observation of the appearance of the LED element mounting module produced using the anisotropic conductive adhesive of the example 2, no dendrite is observed after the high-temperature and high-humidity test of 500 hours, and the migration resistance is also satisfactory.

Furthermore, the electrical characteristics remained the same from the initial state, and the conduction reliability is also satisfactory.

### <Example 3>

The resin cured material of example 3 where the light reflective metal layer of the conductive particles is made of nickel/gold plating and where the thickness of the coating layer is thinner than in the example 2 shows a reflectance of 24%, and did not reach the resin cured materials of the examples 1 and 2 but is on a practical level.

In the observation of the appearance of the LED element mounting module produced using the anisotropic conductive adhesive of example 3, no dendrite is observed after the high-temperature and high-humidity test of 500 hours, and the migration resistance is also satisfactory.

Furthermore, the electrical characteristics remained the same from the initial state, and the conduction reliability is also satisfactory.

### <Example 4>

The resin cured material of example 4 where the light reflective metal layer of the conductive particles is made of pure silver and where the thickness of the coating layer is thinner than in example 1 shows a reflectance of 26%, and shows a value comparable to that in the comparative example 1 where the conductive particles whose outermost layer is made of pure silver.

In the observation of the appearance of the LED element mounting module produced using the anisotropic conductive adhesive of example 4, no dendrite is observed after the high-temperature and high-humidity test of 500 hours, and the migration resistance is also satisfactory.

Furthermore, the electrical characteristics remained the same from the initial state, and the conduction reliability is also satisfactory.

### <Example 5>

The resin cured material of example 5 where the conductive particles in which the light reflective metal layer is made of nickel are used shows a reflectance of 39%, which is equivalent to that in example 1. However, because in the observation of the appearance after the high-temperature and high-humidity test of 500 hours, dendrite is observed, and thus, the example 1 is more excellent.

### <Comparative example 1>

The anisotropic conductive adhesive of comparative example 1 where the conductive particles without providing a coating layer on the light reflective metal layer of pure silver are used shows a reflectance of 40%, which is the most satisfactory. However, in the observation of the appearance after the high-temperature and high-humidity test of 100 hours, dendrite is observed, and the migration resistance is poor as compared with those of the examples 1 to 4.

In the continuity test, a short circuit or the like is not identified until 500 hours but a broken wire is identified when 1000 hours is reached.

### <Comparative example 2>

The resin cured material of comparative example 2 where the light reflective metal layer of the conductive particles is made of nickel and where the coating layer is made of gold (Au) has satisfactory migration resistance and conduction reliability but shows a reflectance of 18%, which is poor as compared with those of the examples 1 to 5.

### <Comparative example 3>

The resin cured material of comparative example 3 where the conductive particles without providing a coating layer on the light reflective metal layer of nickel are used, has satisfactory migration resistance and conduction reliability but shows a reflectance of 15%, which is extremely poor as compared with those of the examples 1 to 5.

As shown in the above results, according to the present invention, it is possible to obtain an anisotropic conductive adhesive for light-emitting elements which has a high light reflectance and an excellent migration resistance.

### List of Reference numerals

- 1: anisotropic conductive adhesive
- 2: insulating adhesive resin
- 3: conductive particle
- 10: light-emitting device
- 20: wiring substrate
- 21: first connection electrode
- 22: second connection electrode
- 30: resin particle
- 31: light reflective metal layer
- 32: coating layer
- 40: light-emitting element
- 41: first connection electrode
- 42: second connection electrode

## Claims

1. An anisotropic conductive adhesive comprising light reflective conductive particles in an insulating adhesive resin,
wherein each of the light reflective conductive particles includes
a light reflective metal layer made of a metal having at least 60% of a reflectance at a peak wavelength of 460 nm formed on a surface of a resin particle as a core, and
a coating layer made of a silver alloy formed on a surface of the light reflective metal layer.

2. The anisotropic conductive adhesive according to claim 1,
wherein the light reflective metal layer is made of at least one metal selected from a group consisting of nickel, gold and silver.

3. A method of manufacturing an anisotropic conductive adhesive including light reflective conductive particles in an insulating adhesive resin,
wherein each of the light reflective conductive particles includes a light reflective metal layer made of a metal having at least 60% of a reflectance at a peak wavelength of 460 nm formed on a surface of a resin particle as a core, and a coating layer made of a silver alloy formed on a surface of the light reflective metal layer,
the method comprising the step of forming the light reflective metal layer by a plating method.

4. A light-emitting device comprising:
a wiring substrate having a connection electrode as a pair; and
a light-emitting element having a connection electrode corresponding to the connection electrode of the wiring substrate as a pair,
wherein an anisotropic conductive adhesive includes light reflective conductive particles in an insulating adhesive resin,
wherein the light reflective conductive particle is formed of the light reflective metal layer made of a metal having at least 60% of a reflectance at a peak wavelength of 460 nm formed on a surface of a resin particle as a core, and a coating layer made of a silver alloy formed on a surface of the light reflective metal layer, and
wherein the light-emitting element is adhered by the anisotropic conductive adhesive onto the wiring substrate, and the connection electrode of the light-emitting element is electrically connected to the corresponding connection electrode of the wiring substrate through the conductive particles of the anisotropic conductive adhesive.

5. A method of manufacturing a light-emitting element, comprising the steps of:
preparing a wiring substrate having a connection electrode as a pair and a light-emitting element having a connection electrode corresponding to the connection electrode of the wiring substrate as a pair,
arranging an anisotropic conductive adhesive between the light-emitting element and the light-emitting element in a manner such that the connection electrode of the wiring substrate is arranged facing direction to the connection electrode of the light-emitting element, and
thermally compressing the light emitting element to the wiring substrate,
wherein an anisotropic conductive adhesive includes light reflective conductive particles in an insulating adhesive resin, and
wherein the light reflective conductive particle is formed of the light reflective metal layer made of a metal having at least 60% of a reflectance at a peak wavelength of 460 nm formed on a surface of a resin particle as a core, and a coating layer made of a silver alloy formed on a surface of the light reflective metal layer.
